# EUROPEAN PATENT APPLICATION

(11) **EP 4 804 189 A1**
(43) Date of publication of application: **09.09.2026**
(21) Application number: 24890124.1
(22) Date of filing: 28.06.2024
(51) Int. Cl.: G11C 5/14

(54) **COMPRESSION ATTACHED MEMORY MODULE AND DEVICE**

(30) Priority: 13.11.2023 CN 202311525966
(71) Applicant: CXMT Corporation, Hefei City, Anhui Province 230601 (CN)
(72) Inventor: CHENG, Jingwei, Hefei, Anhui 230601 (CN)
(74) Representative: Gulde & Partner
(86) International application number: PCT/CN2024/102462
(87) International publication number: WO 2025/102755

(57) **Abstract**

The present disclosure provides a compress attached memory module and a device, and relates to the field of semiconductor technologies. The compress attached memory module includes: a compress attached memory circuit board; a plurality of memory chips, arranged on the compress attached memory circuit board; and a power management apparatus, arranged on the compress attached memory circuit board and electrically connected to the plurality of memory chips, where the power management apparatus includes a preset quantity of power management integrated circuits and is configured to provide electric energy generated by the preset quantity of power management integrated circuits to the plurality of memory chips as electric energy for power supply, where the preset quantity of the power management integrated circuits in the power management apparatus is preset according to power demand of the plurality of memory chips.

## Description

### CROSS-REFERENCE TO RELATED APPLICATIONS

The present application is presented based on and claims priority to Chinese Patent Application No. 202311525966.2 filed on November 13, 2023, which is incorporated herein by reference in its entirety.

### TECHNICAL FIELD

The present disclosure relates to the field of semiconductor technologies, in particular to a compress attached memory module and a device.

### BACKGROUND

With the development of semiconductor technologies, the compress attached memory module (CAMM) has become one of the important research directions of semiconductor technologies due to its thinner thickness, better heat dissipation effect, and lower power consumption.

However, there is currently a lack of a power supply scheme suitable for the compress attached memory modules themselves.

Therefore, how to provide a compress attached memory module with a power supply scheme suitable for itself has become an urgent technical problem to be solved.

### SUMMARY

The present disclosure provides a compress attached memory module and a device, which overcomes, at least to some extent, the problem that the compress attached memory module lacks a power supply scheme suitable for its own power supply requirements.

Additional features and advantages of the present disclosure will become apparent from the detailed description below, or will be learned in part by practice of the present disclosure.

According to an aspect of the present disclosure, a compress attached memory module is provided. The module includes:
a compress attached memory circuit board;
a plurality of memory chips, arranged on the compress attached memory circuit board; and
a power management apparatus, arranged on the compress attached memory circuit board and electrically connected to the plurality of memory chips, where the power management apparatus includes a preset quantity of power management integrated circuits and is configured to provide electric energy generated by the preset quantity of power management integrated circuits to the plurality of memory chips as electric energy for power supply, where the preset quantity of the power management integrated circuits in the power management apparatus is preset according to power demand of the plurality of memory chips.

In one embodiment, the power management apparatus includes a plurality of power management integrated circuits, where the power management integrated circuit includes a first power supply pin, and the first power supply pins of the plurality of power management integrated circuits are connected to provide electric energy generated by the plurality of power management integrated circuits to the plurality of memory chips through the connected first power supply pins.

In one embodiment, the first power supply pin includes N power transmission pins, and each power transmission pin is configured to output a power supply voltage, where i-th power transmission pins of the plurality of power management integrated circuits are connected to provide the power supply voltages outputted from the connected i-th power transmission pins to the plurality of memory chips, where N is an integer greater than or equal to 1, and i is any integer less than or equal to N.

In one embodiment, the module further includes: a serial presence detect, configured to store preset power supply quantity information, where the preset power supply quantity information is defined to indicate a quantity of the power management integrated circuits in the power management apparatus.

In one embodiment, the power management integrated circuit further includes a mode register, and the mode register is configured to store preset power supply configuration information of the power management integrated circuit to which the mode register belongs, where the preset power supply configuration information is configured by a chip control apparatus based on the preset power supply quantity information in the serial presence detect.

In one embodiment, the serial presence detect includes a first communication pin, and each power management integrated circuit includes a second communication pin, where the first communication pin is separately connected to the second communication pin of each power management integrated circuit to enable a communication connection between the serial presence detect and each power management integrated circuit.

In one embodiment, the serial presence detect includes a first power pin, and each power management integrated circuit further includes a second power supply pin,
where when the power management apparatus includes a plurality of power management integrated circuits, the second power supply pin of a target power management integrated circuit in the power management apparatus is connected to the first power pin, and the second power supply pins of other power management integrated circuits except the target power management integrated circuit in the power management apparatus are idle, so that electric energy outputted from the second power supply pin of the target power management integrated circuit is provided to the serial presence detect as electric energy for power supply for the serial presence detect.

In one embodiment, each power management integrated circuit includes a status signal pin, and the status signal pin is configured to output a first level indicating that each power management integrated circuit is normal or a second level indicating that each power management integrated circuit is faulty, where when the power management apparatus includes a plurality of power management integrated circuits, the status signal pins of the plurality of power management integrated circuits are connected to a status signal transmission line, where when the status signal pins of one or more power management integrated circuits output the second level, a level on the status signal transmission line is adjusted to the second level, and the second level on the status signal transmission line represents a fault in the power management apparatus.

In one embodiment, each power management integrated circuit includes an enable pin, and the enable pin is configured to turn on or turn off each power management integrated circuit, where the enable pin of each power management integrated circuit is configured to receive a control command sent by the chip control apparatus, and the control command is defined to turn on or turn off each power management integrated circuit.

In one embodiment, each power management integrated circuit includes a communication address pin, and the communication address pin is configured to indicate a communication address of each power management integrated circuit, where the communication address pins of the plurality of power management integrated circuits correspond to different voltages, and different voltages represent different communication addresses.

In one embodiment, the first power supply pin of one power management integrated circuit among the plurality of power management integrated circuits is directly connected to a first conductive wire, and the first power supply pins of other power management integrated circuits among the plurality of power management integrated circuits are connected to the first conductive wire or the first power supply pin of the one power management integrated circuit through connectors.

In one embodiment, the connector includes: one or more of a resistor with a preset resistance value, a connecting wire, a switching element, and a fuse device.

In one embodiment, the connector includes a fuse device, and the fuse device is a fuse or an antifuse,
where for each other power management integrated circuit, when the fuse device corresponding to each other power management integrated circuit is in a low resistance state, each other power management integrated circuit supplies power to the plurality of memory chips; when the fuse device is in a high resistance state, each other power management integrated circuit does not supply power to the plurality of memory chips.

In one embodiment, a resistance state of the fuse device is adjusted by a test machine when an actual quantity of the power management integrated circuits supplying power is incorrect.

In one embodiment, the test machine determines whether there is an error in the actual quantity based on preset power supply quantity information, where the preset power supply quantity information is stored in a serial presence detect, and is defined to indicate a quantity of the power management integrated circuits in the power management apparatus. When the actual quantity is incorrect and the actual quantity is larger than the quantity indicated by the preset power supply quantity information, the test machine adjusts a first target fuse device to be in a high resistance state, so as to disconnect the power management integrated circuit corresponding to the first target fuse device from the power management apparatus; when the actual quantity is incorrect and the actual quantity is less than the quantity indicated by the preset power supply quantity information, the test machine adjusts the fuse device to be in a low resistance state, so as to connect the power management integrated circuit corresponding to a second target fuse device to the power management apparatus.

In one embodiment, each power management integrated circuit is configured to provide electric energy for power supply to a portion of the plurality of memory chips.

In one embodiment, the plurality of memory chips may be divided into a plurality of groups, each group of memory chips belongs to one memory channel, each power management integrated circuit corresponds to at least one memory channel, and each power management integrated circuit is configured to provide electric energy for power supply to the memory chips in the corresponding memory channel.

According to another aspect of the present disclosure, an electronic device is provided. The device includes the above compress attached memory module.

According to the compress attached memory module and the device provided in the embodiments of the present disclosure, the preset quantity of the power management integrated circuits in the power management apparatus can be flexibly set based on the power demand of the memory chips, so that the electric energy generated by the preset quantity of power management integrated circuits can flexibly meet the power demand of various compress attached memory modules, avoiding situations such as voltage drop caused by insufficient power supply. Furthermore, according to the technical solutions provided in the embodiments of the present disclosure, the flexible power supply to the compress attached memory module can be realized while ensuring the stability of the power supply, so that the compress attached memory module can have a power supply scheme suitable for itself.

It should be understood that both the foregoing general description and the subsequent detailed description are exemplary and explanatory only and are not intended to limit the present disclosure.

### BRIEF DESCRIPTION OF THE DRAWINGS

The drawings, which are incorporated in and constitute a part of this specification, illustrate embodiments consistent with the present disclosure and, together with the specification, serve to explain the principles of the present disclosure. It is apparent that the drawings in the description below are only for some embodiments of the present disclosure, and for those of ordinary skill in the art, other drawings may be acquired according to the drawings without creative efforts.
FIG. 1 illustrates a schematic structural diagram of a compress attached memory module according to an embodiment of the present disclosure;
FIG. 2 illustrates a schematic structural diagram of a compress attached memory module according to an embodiment of the present disclosure;
FIG. 3 illustrates a schematic structural diagram of an exemplary compress attached memory module according to an embodiment of the present disclosure;
FIG. 4 illustrates a schematic structural diagram of an exemplary power management integrated circuit according to an embodiment of the present disclosure;
FIG. 5 illustrates a schematic structural diagram of yet another exemplary compress attached memory module according to an embodiment of the present disclosure;
FIG. 6 illustrates a schematic structural diagram of still another exemplary compress attached memory module according to an embodiment of the present disclosure;
FIG. 7 illustrates a schematic structural diagram of another compress attached memory module according to an embodiment of the present disclosure;
FIG. 8 illustrates a schematic structural diagram of another exemplary power management integrated circuit according to an embodiment of the present disclosure;
FIG. 9 illustrates a schematic structural diagram of yet another exemplary power management integrated circuit according to an embodiment of the present disclosure;
FIG. 10 illustrates a schematic structural diagram of still another exemplary power management integrated circuit according to an embodiment of the present disclosure;
FIG. 11 illustrates a schematic structural diagram of still another exemplary power management integrated circuit according to an embodiment of the present disclosure;
FIG. 12 illustrates a schematic structural diagram of still another exemplary power management integrated circuit according to an embodiment of the present disclosure;
FIG. 13 illustrates a schematic structural diagram of still another exemplary power management integrated circuit according to an embodiment of the present disclosure;
FIG. 14 illustrates a schematic structural diagram of still another exemplary power management integrated circuit according to an embodiment of the present disclosure;
FIG. 15 illustrates a schematic structural diagram of an exemplary first power management integrated circuit according to an embodiment of the present disclosure;
FIG. 16 illustrates a schematic structural diagram of an exemplary second power management integrated circuit according to an embodiment of the present disclosure; and
FIG. 17 illustrates a schematic structural diagram of an exemplary serial presence detect according to an embodiment of the present disclosure.

### DETAILED DESCRIPTION

Exemplary embodiments will now be described more comprehensively with reference to the accompanying drawings. However, the exemplary embodiments may be implemented in many different forms and should not be construed as limited to the examples set forth herein; on the contrary, these embodiments are provided so that the present disclosure will be more comprehensive and complete, and will fully convey the concepts of the exemplary embodiments to those skilled in the art. The described characteristics, structures, or features may be combined in any suitable manner in one or more embodiments.

Indeed as the background, the compress attached memory module (CAMM) has become one of the important research directions of semiconductor technologies.

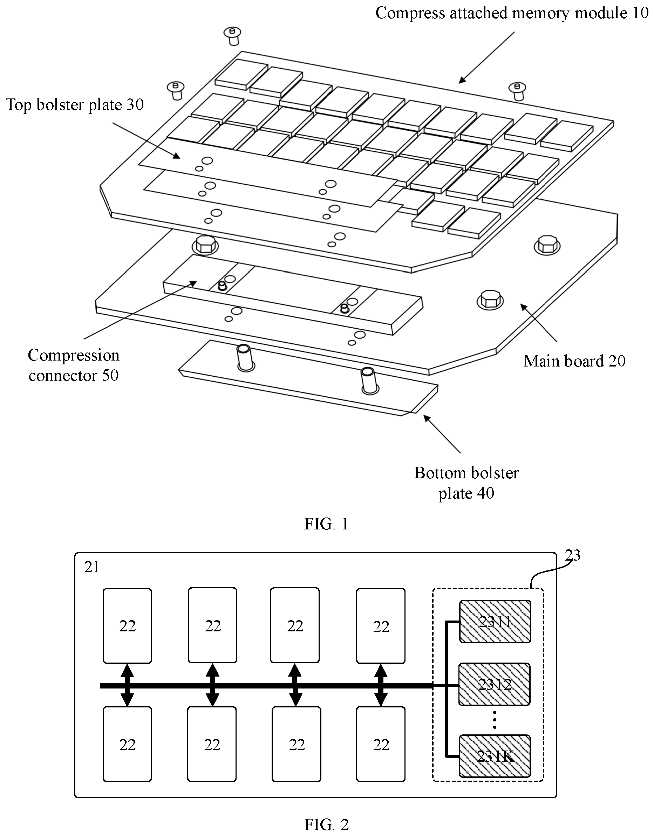

FIG. 1 illustrates a schematic structural diagram of a compress attached memory module according to an embodiment of the present disclosure. As shown in FIG. 1, a compress attached memory module 10 and a main board 20 may be arranged between a top bolster plate 30 and a bottom bolster plate 40, and the compress attached memory module 10 may be fixed on a compression connector 50 of the main board 20 by using screws. In some embodiments, the outward connection end of the compress attached memory module 10 may be a contact. Accordingly, the compress attached memory module 10 may realize the circuit connection and fixation to the main board by combining contacts and screws.

However, the standard for the compress attached memory module has not been established. The inventors discovered through research that in an exemplary scenario, a small outline dual in-line memory module (SoDIMM) has only one memory channel, while the compress attached memory module may have two independent memory channels. Therefore, the load of the compress attached memory module is twice that of the small outline dual in-line memory module theoretically. Therefore, if the power supply design scheme of the small outline dual in-line memory module is borrowed, that is, if a power management integrated circuit (PMIC) is used to supply power to the memory chip in the compress attached memory module, under extreme conditions, the power demand of the compress attached memory module may not be met, resulting in voltage drop, etc.

Therefore, how to provide a compress attached memory module with a power supply scheme suitable for itself has become an urgent technical solution to be solved.

Accordingly, the embodiments of the present disclosure provide a compress attached memory module and a device, which can be applied in semiconductor storage scenarios, for example, in a module design scenario, especially in a power supply design scenario of a CAMM module. According to the technical solutions provided in the embodiments of the present disclosure, the flexible power supply to the compress attached memory module can be realized while ensuring the stability of the power supply, so that the compress attached memory module can have a power supply scheme suitable for itself.

Before starting to explain the technical solutions provided in the embodiments of the present disclosure, technical terms related to the embodiments of the present disclosure will be explained first.
(1) Power Management Integrated Circuit (PMIC), i.e., an integrated circuit for voltage conversion, voltage regulation, and battery management. Illustratively, in the field of semiconductor technologies, an important role of the power management integrated circuit may be to provide power supply support for other chips (such as memory chips) on the memory module.
(2) Serial Presence Detect (SPD), i.e., a chip that is configured to store the SPD information of the module. Illustratively, the SPD information includes the important information of the memory module, such as chip information of the memory mode, module manufacturer information, operating frequency, operating voltage, speed, capacity, voltage, and row and column address bandwidth. Illustratively, the serial presence detect may be an electrically erasable programmable read-only memory (EEPROM). Illustratively, a chip control apparatus may access the SPD information in the serial presence detect through an inter-integrated circuit (I2C) bus or a system management bus (SMBus).

After introducing the above technical terms, the technical solutions provided in the embodiments of the present disclosure will be explained below.

FIG. 2 illustrates a schematic structural diagram of a compress attached memory module according to an embodiment of the present disclosure. As shown in FIG. 2, a compress attached memory module 20 may include a compress attached memory circuit board 21, a plurality of memory chips 22, and a power management apparatus 23. The compress attached memory module may have two independent memory channels. Next, the parts of the compress attached memory module will be explained in sequence.

The compress attached memory circuit board 21 may be a circuit board in the compress attached memory module 20 for realizing the electrical connection between devices, for example, a printed circuit board (PCB), and the specific form of the compress attached memory module 21 is not limited.

The memory chip 22 may be arranged on the compress attached memory circuit board 10.

In the arrangement method, in some embodiments, the memory chip 22 may be arranged on one side surface of the compress attached memory circuit board 10. In other embodiments, the memory chip 22 may be arranged on both side surfaces of the compress attached memory circuit board 10.

In the specific form, in some embodiments, the memory chip 22 may be a chip for data storage. Illustratively, the memory chip 22 may be a dynamic random access memory (DRAM) chip, a static random-access memory (SRAM) chip, or a flash memory chip. For example, the memory chip 2 may be a dual data rate SDRAM (DDR SDRAM) or a low power dual data rate SDRAM (LPDDR SDRAM). For example, the semiconductor memory may be DDR5, DDR6, LPDDR4, LPDDR5, LPDDR6, etc., and the specific form of the memory chip 22 is not limited in the present disclosure.

After introducing the memory chip 22, the power management apparatus 23 will be explained below.

The power management apparatus 23 may be arranged on the compress attached memory circuit board 21 and electrically connected to the plurality of memory chips 22. The power management apparatus 23 includes a preset quantity (for example, K) of power management integrated circuits 2311 to 231K, and is configured to provide the electric energy generated by the preset quantity of power management integrated circuits 2311 to 231K to the plurality of memory chips 20 as electric energy for power supply. The quantity of the power management integrated circuits (i.e., K) in the power management apparatus 23 is set according to the power demand of the plurality of memory chips 20.

Next, the power management apparatus 23 will be explained in detail from the arrangement position, the specific structure, the quantity of the power management integrated circuits, the power supply method, etc.

In the arrangement position, in some embodiments, the power management integrated circuits 2311 to 231K may be arranged on a raw card of the compress attached memory module.

In the specific structure, in some embodiments, in order to provide electric energy for power supply to the memory chip, when the power management apparatus 23 includes a plurality of power management integrated circuits 2311 to 231K, each power management integrated circuit includes a first power supply pin A1, where the first power supply pin A1 may be a pin for providing electric energy for power supply to the memory chip.

Specifically, the first power supply pins A1 of the plurality of power management integrated circuits are connected to provide the electric energy generated by the plurality of power management integrated circuits 2311 to 231K to the plurality of memory chips through the connected first power supply pins A1. Illustratively, the first power supply pins of the plurality of power management integrated circuits 2311 to 231K may be jointly connected to the same first conductive wire and thus provide the electric energy generated by the plurality of power management integrated circuits to the plurality of memory chips 22 through the first conductive wire.

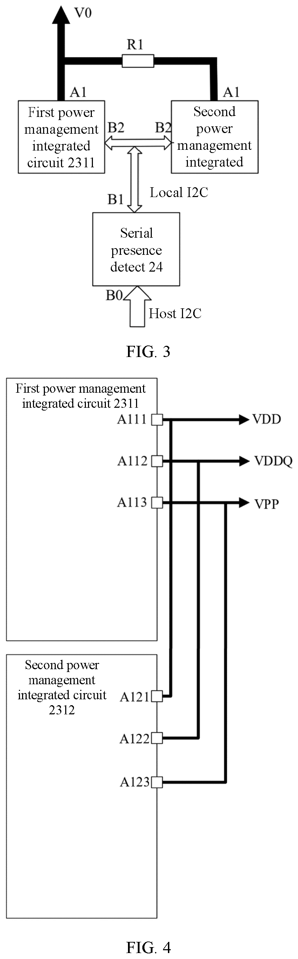

In one embodiment, FIG. 3 illustrates a schematic structural diagram of an exemplary compress attached memory module according to an embodiment of the present disclosure. As shown in FIG. 3, in the case that the power management apparatus 23 includes two power management integrated circuits, i.e., a first power management integrated circuit 2311 and a second power management integrated circuit 2312, the first power supply pins A1 of the first power management integrated circuit 2311 and the second power management integrated circuit 2312 are connected to provide the electric energy generated by the first power management integrated circuit 2311 and the second power management integrated circuit 2312 to the memory chip through the connected first power supply pins A1. For example, the power supply voltage V0 outputted after the first power supply pins A1 of the first power management integrated circuit 2311 and the second power management integrated circuit 2312 are connected may be provided to the memory chip as the power voltage for the memory chip.

In the embodiments of the present disclosure, a plurality of power management integrated circuits may jointly supply power to a plurality of memory chips through the first power supply pins, thereby meeting the power demand of the plurality of memory chips, avoiding situations such as voltage drop caused by insufficient power supply, and ensuring the stability of the power supply.

In one embodiment, in order to provide a plurality of power supply voltages to the memory chip, each first power supply pin A1 includes N power transmission pins, and each power transmission pin is configured to output a power supply voltage. N is an integer greater than or equal to 1. Illustratively, FIG. 4 illustrates a schematic structural diagram of an exemplary power management integrated circuit according to an embodiment of the present disclosure. As shown in FIG. 4, the first power management integrated circuit 2311 may include a plurality of power transmission pins, such as power transmission pins A111, A112, and A113. The second power management integrated circuit 2312 may include a plurality of power transmission pins, such as power transmission pins A121, A122, and A123. In one specific embodiment, in order to ensure stable voltage output, each power transmission pin may include a switching voltage pin, a start-up voltage pin, and a feedback voltage pin. For example, taking the power transmission pins A111 and A121 as examples, they may include a switching voltage pin SWA, a start-up voltage pin SWA_BOOT, and a feedback voltage pin SWA_FB_P. Taking the power transmission pins A112 and A122 as examples, they may include a switching voltage pin SWB, a start-up voltage pin SWB_BOOT, and a feedback voltage pin SWB_FB_P. Taking the power transmission pins A113 and A123 as examples, they may include a switching voltage pin SWC, a start-up voltage pin SWC_BOOT, and a feedback voltage pin SWC_FB_P.

Specifically, i-th power transmission pins of the plurality of power management integrated circuits are connected to provide the power supply voltage outputted from the connected i-th power transmission pins to the plurality of memory chips. i is any integer less than or equal to N. Illustratively, the i-th power transmission pin may be connected to the i-th first conductive wire to provide the power supply voltage outputted from the i-th power transmission pin to the plurality of memory chips through the i-th first conductive wire.

In one embodiment, with further reference to FIG. 4, the first power transmission pin A111 of the first power management integrated circuit 2311 is connected to the first power transmission pin A121 of the second power management integrated circuit 2312 to output a first power supply voltage VDD; the second power transmission pin A112 of the first power management integrated circuit 2311 is connected to the second power transmission pin A122 of the second power management integrated circuit 2312 to output a second power supply voltage VDDQ; the third power transmission pin A113 of the first power management integrated circuit 2311 is connected to the third power transmission pin A123 of the second power management integrated circuit 2312 to output a third power supply voltage VPP.

According to the embodiments of the present disclosure, N power transmission voltages may be provided to the memory chip through N power transmission pins by connecting N power transmission pins of the plurality of power management integrated circuits, so that the power management apparatus may realize the stable output of the plurality of power transmission voltages, and the power supply capacity of the power management apparatus is improved.

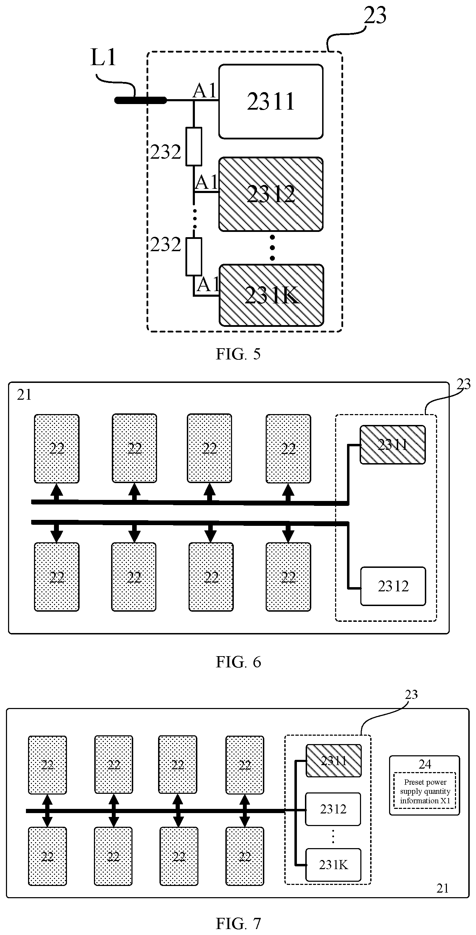

In some embodiments, FIG. 5 illustrates a schematic structural diagram of yet another exemplary compress attached memory module according to an embodiment of the present disclosure. As shown in FIG. 5, the first power supply pin A1 of one power management integrated circuit (such as the first power management integrated circuit 2311) among the plurality of power management integrated circuits 2311 to 231K is directly connected to a first conductive wire L1, and the first power supply pins A1 of other power management integrated circuits (such as the second power management integrated circuits 2312 to 231K) among the plurality of power management integrated circuits 2311 to 231K are connected to the first conductive wire L1 or the first power supply pin A1 of the one power management integrated circuit (such as the first power management integrated circuit 2311) through connectors 232.

According to the embodiment, the plurality of power management integrated circuits 2311 to 231K may be connected to the first conductive wire L1 through the connectors 232, so that the power supply voltage that meets the power demand of the compress attached memory module may be outputted through the first conductive wire L1, and the power supply quality of the power management apparatus 23 is ensured.

In one embodiment, the connector 232 may be an electrical element for electrical connection. Illustratively, the connector 232 may include: one or more of a resistor with a preset resistance value, a connecting wire, a switching element, and a fuse device.

The resistor may be an electrical element with ohmic features. Illustratively, with further reference to FIG. 3, the connector 232 may be the resistor R1 in FIG. 3. For example, in order to improve power supply quality, the preset resistance value of the resistor R1 may be 0 ohms. It should be noted that the preset resistance value may also be selected according to actual situations and specific scenarios, which is not particularly limited. Furthermore, it should also be noted that the resistor of 0 ohms in the embodiments of the present disclosure may refer to a resistor with a very small resistance value.

The connecting wire may be a line that performs the electrical connection between devices, such as a conductive wire.

The switching element may be an electrical device with an on-off function, for example, a semiconductor switch such as a metal oxide semiconductor (MOS) field effect transistor, which is not particularly limited. It should be noted that the switching element may further be other electrical elements that can realize the switching function, which is not particularly limited.

The fuse device may be an electrical element that switches between a low resistance state and a high resistance state through a fuse operation. Illustratively, the fuse device may be a one-time programmable (OTP) device such as a fuse or an antifuse, which is not particularly limited.

According to the embodiment, the electrical connection of the plurality of power management integrated circuits can be realized through devices such as a resistor with a preset resistance value, a connecting wire, a switching element, and a fuse device, thereby ensuring the power supply capacity of the power management apparatus 23. Optionally, in the case that the connector 232 includes a switching element and/or a fuse device, the flexible power supply of the power management apparatus 20 can be realized.

In one embodiment, for each other power management integrated circuit, when the fuse device corresponding to the each other power management integrated circuit is in a low resistance state, the each other power management integrated circuit supplies power to the plurality of memory chips.

When the fuse device is in a high resistance state, the each other power management integrated circuit does not supply power to the plurality of memory chips.

According to the embodiment, the flexible power supply of the plurality of power management integrated circuits can be realized by controlling the resistance state of the fuse device.

In one specific embodiment, the resistance state of the fuse device is adjusted by a test machine when the actual quantity of the power management integrated circuits supplying power is incorrect. For example, during the chip testing, if the actual quantity of the power management integrated circuits is found to be inconsistent with the pre-designed quantity, the actual quantity of the power management integrated circuits that are supplying power may be adjusted to be consistent with the pre-designed quantity by adjusting the resistance state of each fuse device.

For example, with further reference to FIG. 3, if the resistor R1 is a fuse device in a low resistance state, the actual quantity of the power management integrated circuits that are supplying power is 2, and if the pre-designed quantity is 1, the fuse device can be adjusted to be in a high resistance state through fuse processing; in this case, the second power management integrated circuit 2312 is disconnected from the power supply line, only the first power management integrated circuit 2311 supplies power to the memory, and the actual quantity of the power management integrated circuits that are supplying power is adjusted to 1, which is consistent with the pre-designed quantity.

For example, the test machine can determine whether there is an error in the actual quantity based on preset power supply quantity information, where the preset power supply quantity information is stored in a serial presence detect, and is defined to indicate the quantity of the power management integrated circuits in the power management apparatus.

When the actual quantity is incorrect and the actual quantity is larger than the quantity indicated by the preset power supply quantity information, the test machine adjusts a first target fuse device to be in a high resistance state, so as to disconnect the power management integrated circuit corresponding to the first target fuse device from the power management apparatus. Illustratively, the power management integrated circuit corresponding to the first target fuse device may be randomly selected from the plurality of power management integrated circuits, or may be selected in a preset manner, which is not particularly limited. For example, if the actual quantity is 5 and the quantity indicated by the preset power supply quantity information is 3, 2 power management integrated circuits may be selected from 5 power management integrated circuits connected to the power management apparatus as the power management integrated circuit corresponding to the first target fuse device, and the selected power management integrated circuits are disconnected from the power management apparatus, so that the remaining 3 power management integrated circuits supply power to the compress attached memory module.

When the actual quantity is incorrect and the actual quantity is less than the quantity indicated by the preset power supply quantity information, the test machine adjusts the fuse device to be in a low resistance state, so as to connect the power management integrated circuit corresponding to a second target fuse device to the power management apparatus. Illustratively, the power management integrated circuit corresponding to the second target fuse device may be randomly selected from the plurality of power management integrated circuits, or may be selected in a preset manner, which is not particularly limited. For example, if the actual quantity is 2 and the quantity indicated by the preset power supply quantity information is 3, 1 power management integrated circuit may be selected from the power management integrated circuits that are not connected to the power management apparatus as the power management integrated circuit corresponding to the second target fuse device, and the selected power management integrated circuit is connected to the power management apparatus, so that the previously connected 2 power management integrated circuits and the newly connected 1 power management integrated circuit jointly supply power to the compress attached memory module.

According to the above embodiment, when the actual quantity of the power management integrated circuits supplying power in the power management apparatus is incorrect, the quantity of the power management integrated circuits connected to the power management apparatus may be adjusted according to the size relationship between the preset power supply quantity information and the actual quantity, so that when the power management apparatus can not normally supply power to the memory chip, the high and low resistance states of the fuse device are adjusted to enable the power management apparatus to meet the power supply requirements of the memory chip, thereby improving the yield of the memory module.

According to the embodiment, when the actual quantity of the power management integrated circuits supplying power in the power management apparatus is incorrect, the error can be corrected through fuse processing at stages such as chip testing, so that the power supply reliability of the power management apparatus is improved, and the yield of the compress attached memory module is further improved.

After introducing the specific structure of the power management apparatus 23 through the above embodiments, the quantity of the power management integrated circuits will be explained below.

In the specific quantity, in some embodiments, the preset quantity of the power management integrated circuits in the power management apparatus 23 (i.e., quantity N) may be any positive integer greater than or equal to 1, for example, may be 1 or 2. It should be noted that the preset quantity of the power management integrated circuits in the embodiments of the present disclosure may be the quantity of the power management integrated circuits on a power supply line connected to the power management apparatus, that is, the quantity of the power management integrated circuits configured to supply power to the memory chip.

In some embodiments, the preset quantity of the power management integrated circuits in the power management apparatus 23 may be determined by the module manufacturer. For example, the quantity of the power management integrated circuits may be determined according to the power demand of the memory chip.

In one embodiment, the module information of the compress attached memory module can be inputted into a preset chip quantity prediction model, and the prediction result outputted by the preset chip quantity prediction model can be determined as the preset quantity of the power management integrated circuits. Illustratively, the module information may be the configuration information of the module, such as one or more of a chip model of the module, a module model, memory rank information, a current parameter of the compress attached memory module, and a module capacity. It should be noted that other information may also be selected as the configuration information according to actual setting situations and specific setting scenarios, which is not particularly limited. Illustratively, the preset chip quantity prediction model may be a neural network model, a mathematical model, etc., which is not particularly limited.

In another embodiment, the actual value of the module information of the compress attached memory module may be acquired, and the quantity of chips corresponding to a preset value range is determined as the preset quantity of the power management integrated circuits in the case that the actual value of the module information is within the preset value range. In one example, the current required for the compress attached memory module may be acquired. In the case that the required current is less than or equal to a preset current threshold, the preset quantity of the power management integrated circuits is 1. In the case that the required current is greater than the preset current threshold, the preset quantity of the power management integrated circuits is 2. For example, continuing with FIG. 3 as an example, when the required current is less than or equal to the preset current threshold, that is, when the current required by the compress attached memory module is smaller, only 1 current management integrated circuit is required to supply power; in this case, the resistor R1 is not required to be welded, and the second power management integrated circuit 2312 is not required to be provided. Furthermore, when the required current is greater than the preset current threshold, that is, when the current required by the compress attached memory module is larger, 2 current management integrated circuits are required to supply power; in this case, the first power management integrated circuit 2311 and the second power management integrated circuit 2312 may be welded together through the resistor R1.

According to the embodiment, the preset quantity of the power management integrated circuits may be accurately set, so that the power supply precision and flexibility of the power management integrated circuits can be improved.

After introducing the quantity of the power management integrated circuits in the power management apparatus, the power supply method of the power management apparatus will be explained in detail below.

In some embodiments, each power management integrated circuit is configured to provide electric energy for power supply to a portion of the plurality of memory chips. Illustratively, the plurality of memory chips may be divided into M groups, N power management integrated circuits correspond one-to-one to N groups of memory chips, and each power management integrated circuit is configured to supply power to the corresponding group of memory chips.

Illustratively, FIG. 6 illustrates a schematic structural diagram of still another exemplary compress attached memory module according to an embodiment of the present disclosure. As shown in FIG. 6, the first power management integrated circuit 2311 may provide electric energy for power supply to the memory chips 22 in a first row, and the second power management integrated circuit 2312 may provide electric energy for power supply to the memory chips 22 in a second row.

In one embodiment, the plurality of memory chips may be divided into a plurality of groups, and each group of memory chips belongs to one memory channel. Each power management integrated circuit corresponds to at least one memory channel, and each power management integrated circuit is configured to provide electric energy for power supply to the memory chips in the corresponding memory channel. Illustratively, continuing with FIG. 6 as an example, if the memory chips 22 in the first row belong to a first memory channel and the memory chips 22 in the second row belong to a second memory channel, then the first power management integrated circuit 2311 may provide electric energy for power supply to each memory chip 22 in the first memory channel, and the second power management integrated circuit 2312 may provide electric energy for power supply to each memory chip in the second memory channel.

The compress attached memory module often has a plurality of independent memory channels, for example, 2 independent DDR5 memory channels may be included. According to the embodiment, the memory chips of each memory channel of the compress attached memory module may be independently powered by one or more power management integrated circuits, so that the power supply requirements of the compress attached memory module are ensured.

According to the embodiments of the present disclosure, the accurate power supply to the compress attached memory module may be realized through the method that each power management integrated circuit is configured to provide electric energy for power supply to a portion of the plurality of memory chips, so that the power supply stability and reliability are improved.

In other embodiments, the output end (e.g., the first power supply pin A1) of each power management integrated circuit of the plurality of power management integrated circuits may be connected together to supply power to each memory chip through the electric energy of the plurality of power management integrated circuits.

According to the compress attached memory module provided in the embodiments of the present disclosure, the preset quantity of the power management integrated circuits in the power management apparatus can be flexibly set based on the power demand of the memory chips, so that the electric energy generated by the preset quantity of power management integrated circuits can flexibly meet the power demand of various compress attached memory modules, avoiding situations such as voltage drop caused by insufficient power supply. Furthermore, according to the technical solutions provided in the embodiments of the present disclosure, the flexible power supply to the compress attached memory module can be realized while ensuring the stability of the power supply, so that the compress attached memory module can have a power supply scheme suitable for itself.

Furthermore, it should be noted that, considering the fact that the compress attached memory module has 2 independent memory channels, and the load of the compress attached memory module is twice that of the small outline dual in-line memory module theoretically, the power supply requirements of the compress attached memory module can be met by 2 memory management integrated circuits, avoiding the risk of voltage drop when the power supply scheme of the small outline dual in-line memory module is used to supply power to the compress attached memory module, and realizing stable power supply to the compress attached memory module.

Furthermore, it should be further noted that, according to the embodiments of the present disclosure, different flexible power schemes may be selected according to the module information of the compress attached memory module (for example, configuration information of the compress attached memory module, and capacity of the compress attached memory module); for example, an optional power supply scheme that 1 power management integrated circuit or 2 power management integrated circuits are used for power supply is selected. Illustratively, when there are fewer memory particles on the compress attached memory module, 1 power management integrated circuit may be used for power supply, so as to reduce the cost of the compress attached memory module when the power supply requirements are met. Furthermore, when there are many memory particles on the compress attached memory module, 2 power management integrated circuits may be used to reduce voltage drops under extreme conditions and improve the stability of the power supply.

FIG. 7 illustrates a schematic structural diagram of another compress attached memory module according to an embodiment of the present disclosure. FIG. 7 is different from FIG. 2 in that the compress attached memory module may further include a serial presence detect 24.

The serial presence detect 24 is configured to store preset power supply quantity information X1. The preset power supply quantity information X1 is defined to indicate the quantity of the power management integrated circuits in the power management apparatus 23. It should be noted that the preset power supply quantity information X1 may further include other power supply configuration information of the power management apparatus 23, which is not particularly limited.

Illustratively, the serial presence detect 24 may include at least one field for storing the preset power supply quantity information X1. Each field may include one or more bits. In the embodiments of the present disclosure, the preset power supply quantity information X1 may be written into the at least one field. For example, the preset power supply quantity information X1 may be written in 1 bit of the serial presence detect 24.

For example, taking the preset power supply quantity information X1 being written into 1 bit as an example, a first value of the bit represents the quantity of 1 (i.e., the compress attached memory module is powered by 1 power management integrated circuit), and a second value of the bit represents the quantity of 2 (i.e., the compress attached memory module is powered by 2 power management integrated circuits). One of the first value and the second value is 0, and the other is 1. According to the embodiment, after configuring the power supply, the quantity of the power management integrated circuits in the power management apparatus 23 may be stored in the preset power supply quantity information X1 of the serial presence detect 24, so as to accurately record the quantity information of the power management integrated circuits for subsequent power supply management.

In one embodiment, the quantity of the power management integrated circuits may be written in the preset power supply quantity information X1 by the module manufacturer after configuring the power management integrated circuits of the power management apparatus 23. For example, if the module manufacturer determines that the compress attached memory module requires 1 power management integrated circuit for power supply, 1 power management integrated circuit is arranged on the compress attached memory module (or a plurality of power management integrated circuits are arranged but only 1 power management integrated circuit is used for power supply), and 0 is written in the bit corresponding to the preset power supply quantity information X1; for another example, if the module manufacturer determines that the compress attached memory module requires 2 power management integrated circuits for power supply, 2 power management integrated circuits are arranged on the compress attached memory module, the first power supply pins of the 2 power management integrated circuits are connected through the connector, and 1 is written in the bit corresponding to the preset power supply quantity information X1.

According to the embodiment, after the module manufacturer completes the configuration of the power management integrated circuits, the quantity of the power management integrated circuits may be written in the preset power supply quantity information of the serial presence detect, so that the accurate quantity of the power management integrated circuits in the compress attached memory module may be acquired based on the preset power supply quantity information in the subsequent manufacturing process of the compress attached memory module, so that the accurate subsequent configuration, subsequent test, and the like can be performed on the compress attached memory module, and the convenience and accuracy of the manufacturing process of the compress attached memory module are improved.

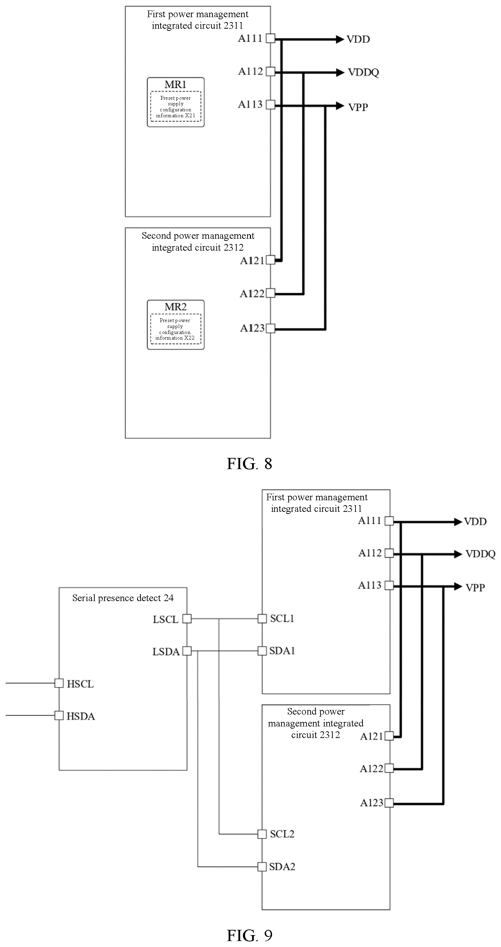

In some embodiments, the power management integrated circuit includes a mode register, and the mode register is configured to store preset power supply configuration information of the power management integrated circuit to which the mode register belongs. The preset power supply configuration information is configured by a chip control apparatus based on the preset power supply quantity information in the serial presence detect. Illustratively, FIG. 8 illustrates a schematic structural diagram of another exemplary power management integrated circuit according to an embodiment of the present disclosure. As shown in FIG. 8, the first power management integrated circuit 2311 may include a first mode register MR1, and the first mode register MR1 stores the preset power supply configuration information X21 of the first power management integrated circuit 2311. The second power management integrated circuit 2312 may include a second mode register MR2, and the second mode register MR2 stores the preset power supply configuration information X22 of the second power management integrated circuit 2312.

The preset power supply configuration information may refer to the power supply configuration information of the power management integrated circuit. Illustratively, the preset power supply configuration information may include one or more of configuration information such as over-voltage, over-current, over-temperature, power-on timing, and power-off timing. It should be noted that, according to actual chip conditions and specific chip scenarios, the preset power supply configuration information may further include other power supply information that needs to be configured, which is not particularly limited.

Illustratively, the mode register may include at least one field for storing the preset power supply configuration information. Each field may include one or more bits. In the embodiments of the present disclosure, the preset power supply configuration information may be written into the at least one field.

The chip control apparatus may refer to an apparatus with a chip control function. Illustratively, the chip control apparatus may be a host device, for example, a system on a chip (SOC), and it should be noted that the chip controller may also be other host devices such as a central processing unit (CPU), which is not particularly limited.

In one embodiment, the chip control apparatus may configure the preset power supply configuration information according to the rule of the preset standard protocol and the quantity indicated by the preset power supply quantity information. The preset specification protocol may be a protocol that specifies the power management integrated circuit. Illustratively, the preset specification protocol may be a standard protocol of the Joint Electron Device Engineering Council (JEDEC).

It should be noted that, in the embodiments of the present disclosure, when there are a plurality of power management integrated circuits, the configuration information of the plurality of power management integrated circuits may be the same or different, which is not particularly limited.

In one embodiment, the chip management apparatus may access the power management integrated circuit through communication buses such as I2C and configure various information in the power management integrated circuit. Optionally, the chip management apparatus may realize the I2C communication with the power management integrated circuit by the serial presence detect and configure the power management integrated circuit by the serial presence detect.

According to the embodiment, the chip control apparatus configures the preset power supply configuration information of the power management integrated circuit based on the preset power supply quantity information in the serial presence detect, such that the accurate and flexible power supply configuration of the power management integrated circuit is realized according to the quantity of the power management integrated circuits, and the power supply reliability and flexibility of the compress attached memory module are improved.

In some embodiments, in order to realize the communication connection between the serial presence detect and each power management integrated circuit, the serial presence detect includes a first communication pin, and each power management integrated circuit includes a second communication pin. The first communication pin is separately connected to the second communication pin of each power management integrated circuit to enable the communication connection between the serial presence detect and each power management integrated circuit. Illustratively, the communication connection may be an I2C communication connection. It should be noted that other communication technologies that can realize the communication between the power management integrated circuit and the serial presence detect, such as I3C, SMBus, and other serial communication connections, may also be selected according to actual communication situations and specific communication scenarios, which is not particularly limited.

In one embodiment, continuing with FIG. 3 as an example, the first communication pin B1 of the serial presence detect 24 may be separately connected to the second communication pin B2 of the first power management integrated circuit 2311 and the second communication pin B2 of the second power management integrated circuit 2312, so as to realize the local I2C communication connection between the serial presence detect 24 and the first power management integrated circuit 2311 and the second power management integrated circuit 2312.

In one embodiment, FIG. 9 illustrates a schematic structural diagram of yet another exemplary power management integrated circuit according to an embodiment of the present disclosure. As shown in FIG. 9, the first communication pin B1 of the serial presence detect 24 may include a first clock line pin LSCL and a first bidirectional data line pin LSDA; the second communication pin B2 of the first power management integrated circuit 2311 may include a second clock line pin SCL1 and a second bidirectional data line pin SDA1; the second power management integrated circuit 2312 may include a third clock line pin SCL2 and a third bidirectional data line pin SDA2.

Specifically, the first clock line pin LSCL of the serial presence detect 24 may be separately connected to the second clock line pin SCL1 and the third clock line pin SCL2, and the first bidirectional data line pin LSDA may be separately connected to the second bidirectional data line pin SDA1 and the third bidirectional data line pin SDA2.

According to the embodiment, the communication connection between the serial presence detect and the power management integrated circuit can be realized by connecting the first communication pin of the serial presence detect to the second communication pin of each power management integrated circuit, thereby facilitating the various management, such as power supply configuration, for the power management integrated circuit.

In one embodiment, with further reference to FIG. 3, the serial presence detect 24 may further include a third communication pin B0, so as to realize the communication connection to the chip control apparatus through the third communication pin B0. Illustratively, the host I2C communication with the chip control apparatus may be realized.

Illustratively, with further reference to FIG. 9, the third communication pin B0 includes a fourth clock line pin HSCL and a fourth bidirectional data line pin HSDA, so as to realize the I2C communication with the chip control apparatus through the fourth clock line pin HSCL and the fourth bidirectional data line pin HSDA.

According to the embodiment, the communication connection between the chip control apparatus and the serial presence detect 24 can be realized through the third communication pin B0, so that the chip control apparatus can perform a communication connection on each power management integrated circuit through the serial presence detect 24, and external devices such as the chip control apparatus can perform power management operations, such as chip configuration, on each power management apparatus.

After introducing the communication method of the compress attached memory module, the power supply method of the compress attached memory module will be introduced below.

In some embodiments, the power management integrated circuits may also supply power to the serial presence detect; accordingly, the serial presence detect 24 includes a first power pin, and each power management integrated circuit further includes a second power supply pin.

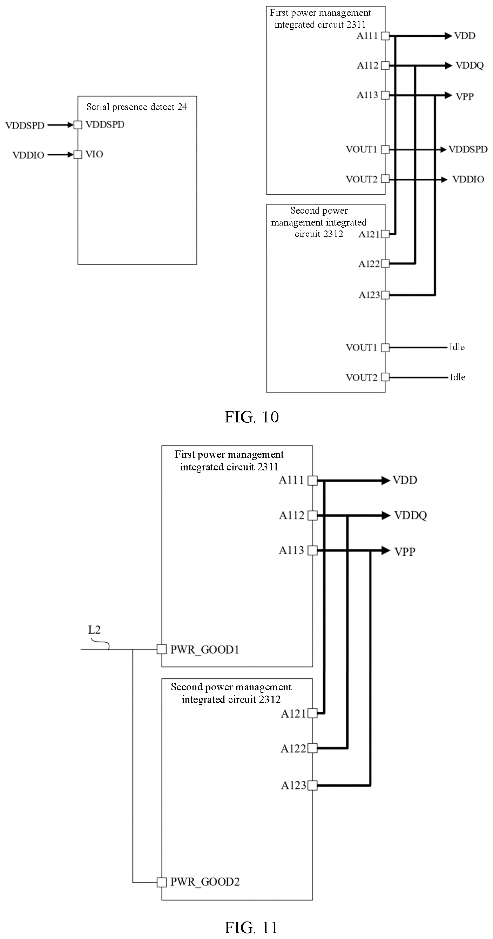

When the power management apparatus includes a plurality of power management integrated circuits, the second power supply pin of a target power management integrated circuit in the power management apparatus is connected to the first power pin, and the second power supply pins of other power management integrated circuits except the target power management integrated circuit in the power management apparatus are idle, so that the electric energy outputted from the second power supply pin of the target power management integrated circuit is provided to the serial presence detect as electric energy for power supply for the serial presence detect. Illustratively, the target power management integrated circuit may be one or more of the power management apparatuses. It should be noted that the target power management apparatus may be selected according to actual power supply situations and specific scenarios, which is not particularly limited. In one embodiment, FIG. 10 illustrates a schematic structural diagram of still another exemplary power management integrated circuit according to an embodiment of the present disclosure. As shown in FIG. 10, the first power pin of the serial presence detect 24 may include an SPD power pin VDDSPD and an input/output power pin VIO, the second power supply pin of the first power management integrated circuit 2311 may include a power supply pin VOUT1 and a power supply pin VOUT2, and the second power supply pin of the second power management integrated circuit 2312 may include a power supply pin VOUT1 and a power supply pin VOUT2.

Illustratively, in the case that the first power management integrated circuit 2311 serves as the target power management integrated circuit and the second power management integrated circuit 2312 serves as one of other power management integrated circuits, the power supply pin VOUT1 of the first power management integrated circuit 2311 is connected to the SPD power pin VDDSPD of the serial presence detect 24 to provide a first power voltage Vddspd to the serial presence detect 24, and the power supply pin VOUT2 of the first power management integrated circuit 2311 is connected to the input/output power pin VIO of the serial presence detect 24 to provide a second power voltage VDDIO to the serial presence detect 24. Furthermore, the power supply pin VOUT1 and the power supply pin VOUT2 of the second power management integrated circuit 2312 remain idle. In this way, the first power management integrated circuit 2311 can supply power to the serial presence detect 24. The first power voltage Vddspd and the second power voltage VDDIO may be the power voltages required by the serial presence detect 24. Illustratively, the first power voltage Vddspd may be 1.8 V (volts), and the second power voltage VDDIO may be 1 V. It should be noted that the first power voltage Vddspd and the second power voltage VDDIO may also be set to other voltage values according to specific scenarios and actual requirements, which is not particularly limited.

In the embodiment, the serial presence detect can be powered through the target power management integrated circuit, so that the normal operation of the serial presence detect can be ensured without an additional external power supply, and the normal operation of the whole compress attached memory module is ensured. Furthermore, by keeping other power management integrated circuits idle, the waste of electric energy of other power management integrated circuits can be avoided, and the electric energy utilization efficiency of the power management integrated circuits can be improved.

In some embodiments, each power management integrated circuit includes a status signal pin. The status signal pin may indicate whether the operating state of the power management integrated circuit is normal or not. Specifically, the status signal pin is configured to output a first level indicating that each power management integrated circuit is normal or a second level indicating that each power management integrated circuit is faulty. One of the first level and the second level is a high level, and the other of the first level and the second level is a low level. Illustratively, the first level may be a high level, and the second level may be a low level. That is, when the power management integrated circuit is normal, the status signal pin thereof is pulled high to a high level; when the power management integrated circuit is faulty, the status signal pin thereof is pulled low to a low level. In one embodiment, FIG. 11 illustrates a schematic structural diagram of still another exemplary power management integrated circuit according to an embodiment of the present disclosure. As shown in FIG. 11, the first power management integrated circuit 2311 may include a first status signal pin PWR_GOOD1, and the second power management integrated circuit 2312 may include a second status signal pin PWR_GOOD2. Taking the first power management integrated circuit 2311 as an example, when the first power management integrated circuit 2311 is normal, the first status signal pin PWR_GOOD1 outputs a high level, and when the first power management integrated circuit 2311 is faulty, the first status signal pin PWR_GOOD1 outputs a low level.

When the power management apparatus includes a plurality of power management integrated circuits, the status signal pins of the plurality of power management integrated circuits are connected to a status signal transmission line. When the status signal pins of one or more power management integrated circuits output the second level, a level on the status signal transmission line is adjusted to the second level, and the second level on the status signal transmission line represents a fault in the power management apparatus. In one embodiment, with further reference to FIG. 11, the first status signal pin PWR_GOOD1 of the first power management integrated circuit 2311 and the second status signal pin PWR_GOOD2 of the second power management integrated circuit 2312 are both connected to a status signal transmission line L2. When the first power management integrated circuit 2311 and/or the second power management integrated circuit 2312 are faulty, the level on the status signal transmission line L2 is a low level; when both the first power management integrated circuit 2311 and the second power management integrated circuit 2312 are normal, the level on the status signal transmission line L2 is a high level.

In the embodiment, when the level of the status signal pin of each power management integrated circuit is the first level, the status signal transmission line is adjusted to the first level; when the level of the status signal pin of any one or more power management integrated circuits is the second level, the status signal transmission line is adjusted to the second level. Since the first level represents that the power management integrated circuit is normal, and the second level represents that the power management integrated circuit is faulty, correspondingly, in the embodiments of the present disclosure, when the power management integrated circuits in the power management apparatus are normal, the status signal transmission line may output the first level representing that the power management apparatus is normal; when any one or more power management integrated circuits in the power management apparatus are faulty, the status signal transmission line may output the second level representing that the power management apparatus is faulty. Thus, the operating state of the power management apparatus can be accurately represented through the output level of the status signal transmission line, so that the fault state of the power management apparatus can be sensed accurately and quickly. Furthermore, the power management apparatus can be managed and maintained conveniently in the subsequent use and test processes when the power management apparatus is sensed to be abnormal.

In some embodiments, in order to control the power management integrated circuits conveniently, each power management integrated circuit includes an enable pin, and the enable pin is configured to turn on or turn off each power management integrated circuit. The enable pin of each power management integrated circuit is configured to receive a control command sent by the chip control apparatus. The control command is defined to turn on or turn off each power management integrated circuit. It should be noted that the control command received by each power management integrated circuit may be the same or different, which is not particularly limited. Furthermore, it should be further noted that, in the embodiments of the present disclosure, the chip control apparatus may directly send a control command to the enable pin, or send the control command to the enable pin under forwarding of other apparatuses or devices, which is not particularly limited.

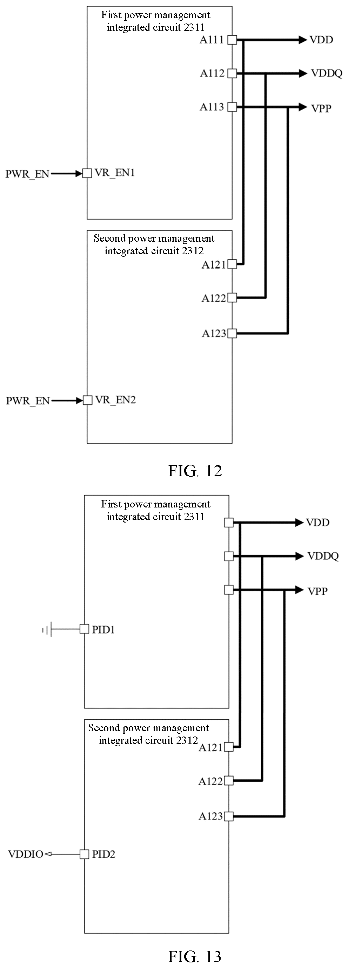

In one embodiment, FIG. 12 illustrates a schematic structural diagram of still another exemplary power management integrated circuit according to an embodiment of the present disclosure. As shown in FIG. 12, the first power management integrated circuit 2311 may include a first enable pin VR_EN1, and the second power management integrated circuit 2312 may include a second enable pin VR_EN2. The first enable pin VR_EN1 and the second enable pin VR_EN2 may receive a control command PWR_EN. Illustratively, the control command PWR_EN may be a level signal, such as a high level indicating to turn on the power management integrated circuit and a low level indicating to turn off the power management integrated circuit.

According to the embodiment, the chip control apparatus can flexibly and accurately control the turn-on or turn-off of each power management integrated circuit through the enable pin of each power management integrated circuit, so that the power management integrated circuits can be used as the granularity to accurately control the power supply of the power management apparatus, which improves the control precision. Furthermore, the quantity of the power management integrated circuits supplying power can be changed in the case that the power supply requirements are changed, such as when a portion of the chips on the compress attached memory module is in operation; for example, a portion of the power management integrated circuits can be turned off, and the remaining portion of the power management integrated circuits is used to supply power to the compress attached memory module. In this way, the power supply precision and the reasonable utilization of electric energy are considered, and the power supply flexibility is improved. Furthermore, when a power management integrated circuit is faulty, each power management integrated circuit or the faulty power management integrated circuit can be quickly turned off, so that the safety of the power management apparatus can be improved.

In some embodiments, in order to realize the correct communication of the power management apparatus, each power management integrated circuit includes a communication address pin, and the communication address pin is configured to indicate the communication address of each power management integrated circuit. The communication address pins of the plurality of power management integrated circuits correspond to different voltages, and different voltages represent different communication addresses. For example, different voltages can be applied to the communication address pins of different power management integrated circuits to represent different communication addresses of the power management integrated circuits.

In one embodiment, FIG. 13 illustrates a schematic structural diagram of still another exemplary power management integrated circuit according to an embodiment of the present disclosure. As shown in FIG. 13, the first power management integrated circuit 2311 may include a first communication address pin PID1, and the second power management integrated circuit 2312 may include a second communication address pin PID2. The first communication address pin PID1 is grounded, and a preset power voltage is applied to the second communication address pin PID2. Illustratively, the preset power voltage may be the second power voltage VDDIO.

According to the embodiment, different communication addresses can be configured for different power management integrated circuits in the same power management apparatus by configuring different voltages for the communication address pins of the power management integrated circuits so as to enable the communication between the power management integrated circuits of the power management apparatus.

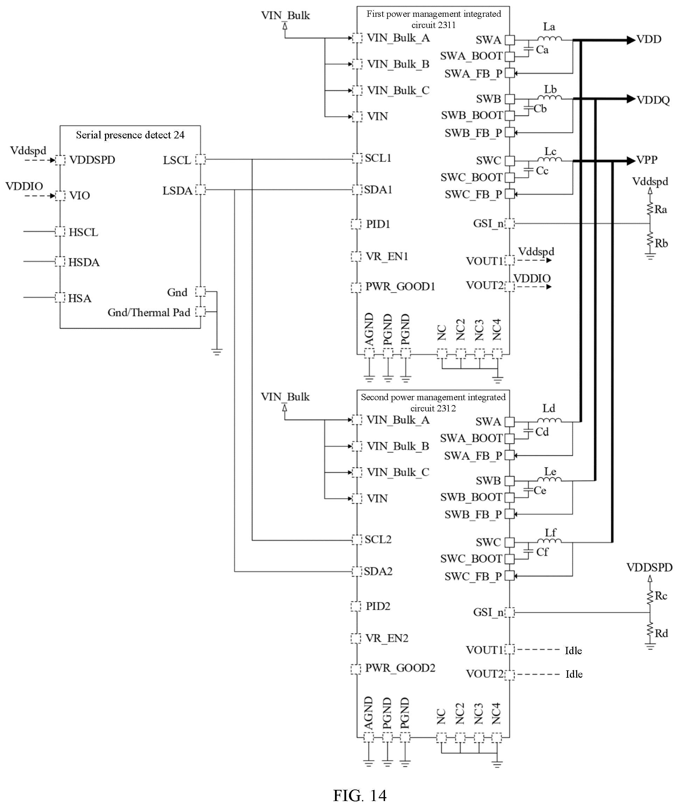

In some embodiments, the power management integrated circuit may further include one or more other pins in addition to the pins shown in combination with the above embodiments. FIG. 14 illustrates a schematic structural diagram of still another exemplary power management integrated circuit according to an embodiment of the present disclosure. As shown in FIG. 14, the power management integrated circuit may further include at least one of the following pins 1-8.

Pin 1. Power ground pin PGND, which is configured to form a discharge path for dangerous currents in a high-power circuit. Illustratively, with further reference to FIG. 14, the power ground pin PGND is grounded.

Pin 2. Analog ground pin AGND, which is configured to form a discharge path for analog signal currents. Illustratively, with further reference to FIG. 14, the analog ground pin AGND is grounded. Pin 3. Empty pins NC and NC1-3, which are not connected to the internal function circuit of the device. Illustratively, with further reference to FIG. 14, the empty pins NC and NC1-3 are grounded.

Pin 4. General state interrupt signal output pin GSI_n, which is configured to output a general state interrupt signal. As shown in FIG. 14, the general state interrupt signal output pin GSI_n may not be connected to the outside of the power management apparatus. For example, the general state interrupt signal output pin GSI_n may be connected to the reference position point of a voltage dividing structure. Illustratively, the voltage dividing structure may include a first voltage dividing resistor Ra and a second voltage dividing resistor Rb. The first power voltage Vddspd is applied to one end of the first voltage dividing resistor Ra, the other end of the voltage dividing resistor Ra and one end of the second voltage dividing resistor Rb are both connected to the reference position point, and the other end of the second voltage dividing resistor Rb is grounded.

Pins 5-8. First voltage input pin VIN_BULK_A, second voltage input pin VIN_BULK_B, third voltage input pin VIN_BULK_C, and fourth voltage input pin VIN, which are separately configured to receive an input voltage VIN_BULK, so that the power management integrated circuit can generate power supply voltages such as the first power supply voltage VDD, the second power supply voltage VDDQ, and the third power supply voltage VPP based on the input voltage VIN_BULK.

In some embodiments, the serial presence detect may further include one or more other pins in addition to the pins shown in combination with the above embodiments. With further reference to FIG. 14, the serial presence detect may further include at least one of pins 9-11.
Pin 9. Address pin HSA.
Pin 10. Ground pin Gnd.

Pin 11. Ground/thermal interface pad pin Gnd/Thermal Pad. With further reference to FIG. 14, the ground/thermal interface pad pin Gnd/Thermal Pad is grounded.

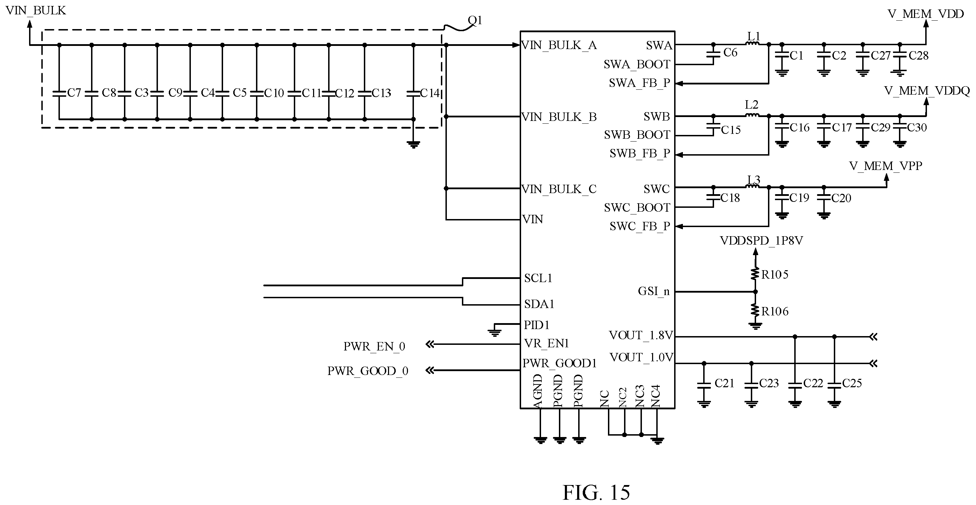

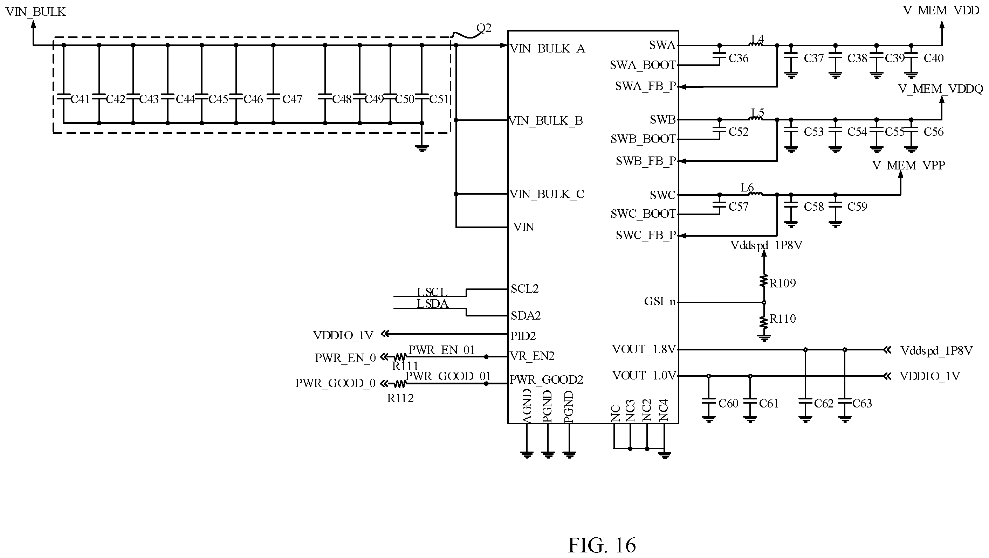

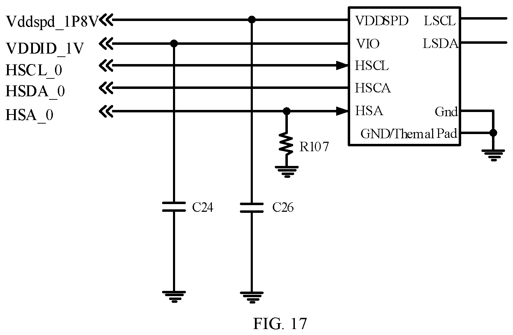

In order to facilitate the overall understanding of the technical solutions provided in the embodiments of the present disclosure, FIG. 15 illustrates a schematic structural diagram of an exemplary first power management integrated circuit according to an embodiment of the present disclosure; FIG. 16 illustrates a schematic structural diagram of an exemplary second power management integrated circuit according to an embodiment of the present disclosure; FIG. 17 illustrates a schematic structural diagram of an exemplary serial presence detect according to an embodiment of the present disclosure. The technical solutions provided in the embodiments of the present disclosure will be explained below in combination with FIGS. 15-17.

As shown in FIGS. 15 and 16, in order to improve the quality of the input voltage VIN_BULK, the first power management integrated circuit further includes a first filter unit Q1, and the second power management integrated circuit further includes a second filter unit Q2. Illustratively, the first filter unit Q1 may include a plurality of capacitors connected in parallel, such as capacitors C3-C5 and capacitors C7-C14. For example, illustratively, the second filter unit Q2 may include a plurality of capacitors connected in parallel, such as capacitors C41-C51. For any one filter unit in the first filter unit Q1 and the second filter unit Q2, at least two capacitors with different capacitance exist in the any one filter unit, so as to realize filtering of different frequencies such as high frequency and low frequency. It should be noted that each capacitor may also be selected as other parameters according to actual scenarios and specific requirements, and the device parameters thereof are not particularly limited.

The first enable pin VR_EN1 of the first power management integrated circuit and the second enable pin VR_EN2 of the second power management integrated circuit may be connected together through a resistor R111 to receive a control command PWR_EN_0. Illustratively, in order to avoid electric energy loss, the resistor R111 may be 0 ohms. It should be noted that the resistance value of the resistor R111 may also be selected as other parameters according to actual scenarios and specific requirements, and the device parameters thereof are not particularly limited.

The first status signal pin PWR_GOOD1 of the first power management integrated circuit and the second status signal pin PWR_GOOD2 of the second power management integrated circuit may be connected together through a resistor R112 to output a status signal PWR_GOOD_0. Illustratively, when the level signal on the first status signal pin PWR_GOOD1 and/or the level signal PWR_GOOD2_01 on the second status signal pin PWR_GOOD2 is a low level, the outputted status signal PWR_GOOD_0 is a low level. Illustratively, in order to avoid electric energy loss, the resistor R112 may be 0 ohms. It should be noted that the resistance value of the resistor R112 may also be selected as other parameters according to actual scenarios and specific requirements, and the device parameters thereof are not particularly limited.

For the first power management integrated circuit and the second power management integrated circuit, the switching voltage pin SWA is connected to the start-up voltage pin SWA_BOOT through a capacitor C6 (or a capacitor C36, it should be noted that, for simplicity, different devices of the second power management integrated circuit and the first power management integrated circuit at the same position are outputted in a bracket manner), the switching voltage pin SWA is connected to an inductor L1 (or an inductor L4), and the other end of the inductor L1 (or the inductor L4) is connected to the feedback voltage pin SWA_FB_P. Illustratively, in order to improve the power transmission quality of the first power supply voltage V_MEM_VDD, the other end of the inductor L1 (or the inductor L4) is separately connected to a capacitor C1, a capacitor C2, a capacitor C27, and a capacitor C28 (or capacitors C37-C40), and the other ends of the capacitor C1, the capacitor C2, the capacitor C27, and the capacitor C28 (or the capacitors C37-C40) are all grounded.

Furthermore, the switching voltage pin SWB is connected to the start-up voltage pin SWB_BOOT through a capacitor C15 (or a capacitor C52), the switching voltage pin SWB is connected to an inductor L2 (or an inductor L5), and the other end of the inductor L2 (or the inductor L5) is connected to the feedback voltage pin SWB_FB_P. Illustratively, in order to improve the power transmission quality of the second power supply voltage V_MEM_VDDQ, the other end of the inductor L2 (or the inductor L5) is separately connected to a capacitor C16, a capacitor C17, a capacitor C29, and a capacitor C30 (or capacitors C53-C56), and the other ends of the capacitor C16, the capacitor C17, the capacitor C29, and the capacitor C30 (or the capacitors C53-C56) are all grounded.

Furthermore, the switching voltage pin SWC is connected to the start-up voltage pin SWC_BOOT through a capacitor C18 (or a capacitor C57), the switching voltage pin SWC is connected to an inductor L3 (or an inductor L6), and the other end of the inductor L3 (or the inductor L6) is connected to the feedback voltage pin SWC_FB_P. Illustratively, in order to improve the power transmission quality of the third power supply voltage V_MEM_VPP, the other end of the inductor L3 (or the inductor L6) is separately connected to a capacitor C19 and a capacitor C20 (or a capacitor C58 and a capacitor C59), and the other ends of the capacitor C19 and the capacitor C20 (or the capacitor C58 and the capacitor C59) are all grounded. It should be noted that each capacitor and each inductor may also be selected as other parameters according to actual scenarios and specific requirements, and the device parameters thereof are not particularly limited.

Furthermore, the general state interrupt signal output pin GSI_n of the first power management integrated circuit may be separately connected to one end of a resistor R105 and one end of a resistor R106, one end of the resistor R105 is configured to receive the first power voltage Vddspd_1P8V, and the other end of the resistor R106 is grounded. The general state interrupt signal output pin GSI_n of the second power management integrated circuit may be separately connected to one end of a resistor R109 and one end of a resistor R110, one end of the resistor R109 is configured to receive the first power voltage Vddspd_1P8V, and the other end of the resistor R110 is grounded. In one embodiment, the resistance values of the resistor R105 and the resistor R109 may be 1 K (kilohm). In another embodiment, the resistance values of the resistor R106 and the resistor R110 may be 0 ohms. It should be noted that each capacitor and each resistor may also be selected as other parameters according to actual scenarios and specific requirements, and the device parameters are not particularly limited.

Furthermore, for any one of the first power management integrated circuit and the second power management integrated circuit, the power supply pin VOUT_1.8V (also called the power supply pin VOUT1) may be grounded through a capacitor C22 (a capacitor C62) and a capacitor C25 (a capacitor C63) separately, and the power supply pin VOUT_1.0V (also called the power supply pin VOUT2) may be grounded through a capacitor C21 (a capacitor C60) and a capacitor C23 (a capacitor C61) separately. It should be noted that each capacitor may also be selected as other parameters according to actual scenarios and specific requirements, and the device parameters thereof are not particularly limited.

Furthermore, with further reference to FIG. 17, the SPD power pin VDDSPD of the serial presence detect may be grounded through a capacitor C26, and the input/output power pin VIO may be grounded through a capacitor C24. It should be noted that each capacitor may also be selected as other parameters according to actual scenarios and specific requirements, and the device parameters thereof are not particularly limited.

It should be noted that other contents of the first power management integrated circuit, the second power management integrated circuit, and the serial presence detect may refer to the relevant description of the above part of the embodiments of the present disclosure, which is not reiterated herein.

Based on the same inventive concept, the embodiments of the present disclosure further provide a power management apparatus. The power management apparatus is arranged on a compress attached memory circuit board of a compress attached memory module, and the power management apparatus is connected to a plurality of memory chips of the compress attached memory module.

Specifically, the power management apparatus includes a preset quantity of power management integrated circuits and is configured to provide the electric energy generated by the preset quantity of power management integrated circuits to the plurality of memory chips as electric energy for power supply.

The preset quantity of the power management integrated circuits in the power management apparatus is related to the power demand of the plurality of memory chips.

In one embodiment, the power management apparatus includes a plurality of power management integrated circuits.

The power management integrated circuit includes a first power supply pin, and the first power supply pins of the plurality of power management integrated circuits are connected to provide the electric energy generated by the plurality of power management integrated circuits to the plurality of memory chips through the connected first power supply pins.

In one embodiment, the first power supply pin includes N power transmission pins, and each power transmission pin is configured to output a power supply voltage.
i-th power transmission pins of the plurality of power management integrated circuits are connected to provide the power supply voltage outputted from the connected i-th power transmission pins to the plurality of memory chips. N is an integer greater than or equal to 1, and i is any integer less than or equal to N.

In one embodiment, the power management integrated circuit further includes a mode register.

The mode register is configured to store preset power supply configuration information of the power management integrated circuit to which the mode register belongs.

The preset power supply configuration information is configured by a chip control apparatus based on the preset power supply quantity information in the serial presence detect.

In one embodiment, in the case that the serial presence detect includes a first communication pin, each power management integrated circuit includes a second communication pin.

The first communication pin is separately connected to the second communication pin of each power management integrated circuit to enable the communication connection between the serial presence detect and each power management integrated circuit.

In one embodiment, the serial presence detect includes a first power pin, and each power management integrated circuit further includes a second power supply pin.

When the power management apparatus includes a plurality of power management integrated circuits, the second power supply pin of a target power management integrated circuit in the power management apparatus is connected to the first power pin, and the second power supply pins of other power management integrated circuits except the target power management integrated circuit in the power management apparatus are idle, so that the electric energy outputted from the second power supply pin of the target power management integrated circuit is provided to the serial presence detect as electric energy for power supply for the serial presence detect.

In one embodiment, each power management integrated circuit includes a status signal pin, the status signal pin is configured to output a first level indicating that each power management integrated circuit is normal or a second level indicating that each power management integrated circuit is faulty.

When the power management apparatus includes a plurality of power management integrated circuits, the status signal pins of the plurality of power management integrated circuits are connected to a status signal transmission line, where when the status signal pins of one or more power management integrated circuits output the second level, a level on the status signal transmission line is adjusted to the second level, and the second level on the status signal transmission line represents a fault in the power management apparatus.

In one embodiment, each power management integrated circuit includes an enable pin, and the enable pin is configured to turn on or turn off each power management integrated circuit.

The enable pin of each power management integrated circuit is configured to receive a control command sent by the chip control apparatus, and the control command is defined to turn on or turn off each power management integrated circuit.

In one embodiment, each power management integrated circuit includes a communication address pin, and the communication address pin is configured to indicate a communication address of each power management integrated circuit, where the communication address pins of the plurality of power management integrated circuits correspond to different voltages, and different voltages represent different communication addresses.

In one embodiment, the first power supply pin of one power management integrated circuit among the plurality of power management integrated circuits is directly connected to a first conductive wire, and the first power supply pins of other power management integrated circuits among the plurality of power management integrated circuits are connected to the first conductive wire or the first power supply pin of the one power management integrated circuit through connectors.

In one embodiment, the connector includes: one or more of a resistor with a preset resistance value, a connecting wire, a switching element, and a fuse device.

In one embodiment, the connector includes a fuse device, and the fuse device is a fuse or an antifuse, where for each other power management integrated circuit, when the fuse device corresponding to each other power management integrated circuit is in a low resistance state, each other power management integrated circuit supplies power to the plurality of memory chips; when the fuse device is in a high resistance state, each other power management integrated circuit does not supply power to the plurality of memory chips.

In one embodiment, a resistance state of the fuse device is adjusted by a test machine when an actual quantity of the power management integrated circuits supplying power is incorrect.

In one embodiment, the test machine determines whether there is an error in the actual quantity based on preset power supply quantity information, where the preset power supply quantity information is stored in a serial presence detect, and is defined to indicate a quantity of the power management integrated circuits in the power management apparatus. When the actual quantity is incorrect and the actual quantity is larger than the quantity indicated by the preset power supply quantity information, the test machine adjusts a first target fuse device to be in a high resistance state, so as to disconnect the power management integrated circuit corresponding to the first target fuse device from the power management apparatus; when the actual quantity is incorrect and the actual quantity is less than the quantity indicated by the preset power supply quantity information, the test machine adjusts the fuse device to be in a low resistance state, so as to connect the power management integrated circuit corresponding to a second target fuse device to the power management apparatus.

In one embodiment, each power management integrated circuit is configured to provide electric energy for power supply to a portion of the plurality of memory chips.

In one embodiment, the plurality of memory chips may be divided into a plurality of groups, each group of memory chips belongs to one memory channel, each power management integrated circuit corresponds to at least one memory channel, and each power management integrated circuit is configured to provide electric energy for power supply to the memory chips in the corresponding memory channel.

According to the power management apparatus provided in the embodiments of the present disclosure, the preset quantity of the power management integrated circuits in the power management apparatus can be flexibly set based on the power demand of the memory chips, so that the electric energy generated by the preset quantity of power management integrated circuits can flexibly meet the power demand of various compress attached memory modules, avoiding situations such as voltage drop caused by insufficient power supply. Furthermore, according to the technical solutions provided in the embodiments of the present disclosure, the flexible power supply to the compress attached memory module can be realized while ensuring the stability of the power supply, so that the compress attached memory module can have a power supply scheme suitable for itself.

It should be noted that the specific contents of the power management apparatus may refer to the relevant description of the above part of the embodiments of the present disclosure in combination with FIGS. 2-17, which is not reiterated herein.

Based on the same inventive concept, the embodiments of the present disclosure further provide a serial presence detect.

Preset power supply quantity information is stored on the serial presence detect, and the preset power supply quantity information is defined to indicate the quantity of the power management integrated circuits in the power management apparatus. The power management apparatus is arranged on a compress attached memory circuit board of a compress attached memory module and is connected to a plurality of memory chips of the compress attached memory module, where the power management apparatus includes a preset quantity of power management integrated circuits and is configured to provide the electric energy generated by the preset quantity of power management integrated circuits to the plurality of memory chips as electric energy for power supply, where the preset quantity of the power management integrated circuits in the power management apparatus is related to the power demand of the plurality of memory chips.

In one embodiment, the serial presence detect includes a first communication pin, and each power management integrated circuit includes a second communication pin, where the first communication pin is separately connected to the second communication pin of each power management integrated circuit to enable the communication connection between the serial presence detect and each power management integrated circuit.

In one embodiment, the serial presence detect includes a first power pin, and each power management integrated circuit further includes a second power supply pin, where when the power management apparatus includes a plurality of power management integrated circuits, the second power supply pin of a target power management integrated circuit in the power management apparatus is connected to the first power pin, and the second power supply pins of other power management integrated circuits except the target power management integrated circuit in the power management apparatus are idle, so that the electric energy outputted from the second power supply pin of the target power management integrated circuit is provided to the serial presence detect as electric energy for power supply for the serial presence detect.

According to the serial presence detect provided in the embodiments of the present disclosure, the preset quantity of the power management integrated circuits in the power management apparatus can be flexibly set based on the power demand of the memory chips, so that the electric energy generated by the preset quantity of power management integrated circuits can flexibly meet the power demand of various compress attached memory modules, avoiding situations such as voltage drop caused by insufficient power supply. Furthermore, according to the technical solutions provided in the embodiments of the present disclosure, the flexible power supply to the compress attached memory module can be realized while ensuring the stability of the power supply, so that the compress attached memory module can have a power supply scheme suitable for itself. Furthermore, after configuring the power supply, the quantity of the power management integrated circuits in the power management apparatus 23 may be stored in the preset power supply quantity information X1 of the serial presence detect 24, so as to accurately record the quantity information of the power management integrated circuits for subsequent power supply management.

It should be noted that the specific contents of the serial presence detect may refer to the relevant description of the above part of the embodiments of the present disclosure in combination with FIGS. 2-17, which is not reiterated herein.

Based on the same inventive concept, the embodiments of the present disclosure further provide an electronic device. The electronic device may include the compress attached memory module provided in any one of the above embodiments of the present disclosure. The specific contents of the compress attached memory module may refer to the relevant description of the embodiments of the present disclosure in combination with FIGS. 2-17, which is not reiterated herein.

The electronic device of the embodiments of the present disclosure may be an electronic device loaded with a memory; illustratively, the electronic device may be a mobile terminal, a computer, a server, a virtual reality device, an Internet-of-Things device, etc.

According to the electronic device provided in the embodiments of the present disclosure, the preset quantity of the power management integrated circuits in the power management apparatus can be flexibly set based on the power demand of the memory chips, so that the electric energy generated by the preset quantity of power management integrated circuits can flexibly meet the power demand of various compress attached memory modules, avoiding situations such as voltage drop caused by insufficient power supply. Furthermore, according to the technical solutions provided in the embodiments of the present disclosure, the flexible power supply to the compress attached memory module can be realized while ensuring the stability of the power supply, so that the compress attached memory module can have a power supply scheme suitable for itself.

In the description of this specification, description with reference to the term "some embodiments", "illustratively", or the like means that a specific feature, structure, material, or characteristic described in conjunction with the embodiment or example is included in at least one embodiment or example of the present disclosure. In this specification, the schematic description of the above terms does not necessarily refer to the same embodiment or example. Moreover, the specific feature, structure, material, or characteristic described may be combined in a suitable manner in any one or more embodiments or examples. Moreover, different embodiments or examples and features of different embodiments or examples described in this specification can be combined by those skilled in the art, as long as they do not contradict each other.

Although the embodiments of the present disclosure have been shown and described above, it should be understood that the embodiments described above are illustrative and should not be construed as limiting the present disclosure, and that changes, modifications, substitutions, and alterations to the embodiments described above may be made by those of ordinary skill in the art within the scope of the present disclosure and therefore changes and modifications made based on the claims and the specification of the present disclosure shall all fall within the scope covered by the present disclosure.

## Claims

1. A compress attached memory module, comprising:
a compress attached memory circuit board (21);
a plurality of memory chips (22), arranged on the compress attached memory circuit board; and
a power management apparatus (23), arranged on the compress attached memory circuit board and electrically connected to the plurality of memory chips, wherein the power management apparatus comprises a preset quantity of power management integrated circuits and is configured to provide electric energy generated by the preset quantity of power management integrated circuits (2311...231K) to the plurality of memory chips as electric energy for power supply, wherein the preset quantity of the power management integrated circuits in the power management apparatus is preset according to power demand of the plurality of memory chips.

2. The module according to claim 1, wherein the power management apparatus comprises a plurality of power management integrated circuits, wherein each power management integrated circuit comprises a first power supply pin (A1), and the first power supply pins of the plurality of power management integrated circuits are connected to provide electric energy generated by the plurality of power management integrated circuits to the plurality of memory chips through the connected first power supply pins.

3. The module according to claim 2, wherein the first power supply pin comprises N power transmission pins, each power transmission pin (A111, A112, A113, A121, A122, A123) is configured to output a power supply voltage, wherein i-th power transmission pins of the plurality of power management integrated circuits are connected to provide the power supply voltages outputted from the connected i-th power transmission pins to the plurality of memory chips, wherein N is an integer greater than or equal to 1, and i is any integer less than or equal to N.

4. The module according to any one of claims 1-3, wherein the module further comprises:
a serial presence detect (24), configured to store preset power supply quantity information, wherein the preset power supply quantity information is defined to indicate a quantity of the power management integrated circuits in the power management apparatus.

5. The module according to claim 4, wherein each power management integrated circuit further comprises a mode register (MR1, MR2), and the mode register is configured to store preset power supply configuration information of the power management integrated circuit to which the mode register belongs, wherein the preset power supply configuration information is configured by a chip control apparatus based on the preset power supply quantity information in the serial presence detect.

6. The module according to claim 4, wherein the serial presence detect comprises a first communication pin (B1), and each power management integrated circuit comprises a second communication pin (B2), wherein the first communication pin is separately connected to the second communication pin of each power management integrated circuit to enable a communication connection between the serial presence detect and each power management integrated circuit.

7. The module according to claim 4, wherein the serial presence detect comprises a first power pin, and each power management integrated circuit further comprises a second power supply pin, wherein when the power management apparatus comprises a plurality of power management integrated circuits, the second power supply pin of a target power management integrated circuit in the power management apparatus is connected to the first power pin, and the second power supply pins of other power management integrated circuits except the target power management integrated circuit in the power management apparatus are idle, so that electric energy outputted from the second power supply pin of the target power management integrated circuit is provided to the serial presence detect as electric energy for power supply for the serial presence detect.

8. The module according to any one of claims 1-7, wherein each power management integrated circuit comprises a status signal pin, and the status signal pin is configured to output a first level indicating that each power management integrated circuit is normal or a second level indicating that each power management integrated circuit is faulty, wherein when the power management apparatus comprises a plurality of power management integrated circuits, the status signal pins of the plurality of power management integrated circuits are connected to a status signal transmission line (L2), wherein when the status signal pins of one or more power management integrated circuits output the second level, a level on the status signal transmission line is adjusted to the second level, and the second level on the status signal transmission line represents a fault in the power management apparatus.

9. The module according to any one of claims 1-8, wherein each power management integrated circuit comprises an enable pin, and the enable pin is configured to turn on or turn off each power management integrated circuit, wherein the enable pin of each power management integrated circuit is configured to receive a control command sent by the chip control apparatus, and the control command is defined to turn on or turn off each power management integrated circuit.

10. The module according to any one of claims 1-9, wherein each power management integrated circuit comprises a communication address pin, and the communication address pin is configured to indicate a communication address of each power management integrated circuit, wherein the communication address pins of the plurality of power management integrated circuits correspond to different voltages, and different voltages represent different communication addresses.

11. The module according to claim 2, wherein the first power supply pin of one power management integrated circuit among the plurality of power management integrated circuits is directly connected to a first conductive wire (L1), and the first power supply pins of other power management integrated circuits among the plurality of power management integrated circuits are connected to the first conductive wire or the first power supply pin of the one power management integrated circuit through connectors (232).

12. The module according to claim 11, wherein the connector comprises: one or more of a resistor with a preset resistance value, a connecting wire, a switching element, and a fuse device.

13. The module according to claim 11, wherein the connector comprises a fuse device, and the fuse device is a fuse or an antifuse,
wherein for each other power management integrated circuit, when the fuse device corresponding to each other power management integrated circuit is in a low resistance state, each other power management integrated circuit supplies power to the plurality of memory chips;
and when the fuse device is in a high resistance state, each other power management integrated circuit does not supply power to the plurality of memory chips.

14. The module according to claim 13, wherein a resistance state of the fuse device is adjusted by a test machine when an actual quantity of the power management integrated circuits supplying power is incorrect.

15. The module according to claim 14, wherein the test machine determines whether there is an error in the actual quantity based on preset power supply quantity information, wherein the preset power supply quantity information is stored in a serial presence detect, and is defined to indicate a quantity of the power management integrated circuits in the power management apparatus; and
wherein when the actual quantity is incorrect and the actual quantity is larger than the quantity indicated by the preset power supply quantity information, the test machine adjusts a first target fuse device to be in a high resistance state, so as to disconnect the power management integrated circuit corresponding to the first target fuse device from the power management apparatus; and
when the actual quantity is incorrect and the actual quantity is less than the quantity indicated by the preset power supply quantity information, the test machine adjusts the fuse device to be in a low resistance state, so as to connect the power management integrated circuit corresponding to a second target fuse device to the power management apparatus.

16. The module according to any one of claims 1-15, wherein each power management integrated circuit is configured to provide electric energy for power supply to a portion of the plurality of memory chips.

17. The module according to claim 16, wherein the plurality of memory chips may be divided into a plurality of groups, each group of memory chips belongs to one memory channel, each power management integrated circuit corresponds to at least one said memory channel, and each power management integrated circuit is configured to provide electric energy for power supply to the memory chips in the corresponding memory channel.

18. An electronic device, comprising:
the compress attached memory module according to any one of claims 1-17.
